Europäisches Patentamt

European Patent Office

Office européen des brevets

(11) Numéro de publication : **0 318 378 B1**

(12) # FASCICULE DE BREVET EUROPEEN

(45) Date de publication du fascicule du brevet :
**29.04.92 Bulletin 92/18**

(51) Int. Cl.$^5$ : **H03K 3/356**

(21) Numéro de dépôt : **88402948.9**

(22) Date de dépôt : **24.11.88**

(54) **Comparateur différentiel latché autostabilisé à horloge unique.**

(30) Priorité : **27.11.87 FR 8716465**

(43) Date de publication de la demande :
**31.05.89 Bulletin 89/22**

(45) Mention de la délivrance du brevet :
**29.04.92 Bulletin 92/18**

(84) Etats contractants désignés :
**CH DE GB LI NL**

(56) Documents cités :
**DE-A- 3 442 649**
**US-A- 3 540 007**
**IEEE JOURNAL OF SOLID-STATE CIRCUITS,**
**vol. SC-12, no. 5, octobre 1977, pages 497-501,**
**IEEE, New York, US; T.R. O'CONNELL et al.:**
**"Two static 4K clocked and nonclocked RAM**
**designs"**

(56) Documents cités :
**IEEE 1983 INTERNATIONAL SYMPOSIUM ON**
**CIRCUITS AND SYSTEMS, Newport Beach,**
**California, 2-4 mai 1983, vol. 3, pages**
**1286-1289, IEEE, New York, US; P.E. ALLEN:**
**"Automated design of MOS of amps"**

(73) Titulaire : **THOMSON COMPOSANTS**
**MICROONDES**
**173, bld Haussmann**
**F-75008 Paris (FR)**

(72) Inventeur : **Thomas, François**
**THOMSON-CSF SCPI 19, avenue de Messine**
**F-75008 Paris (FR)**
Inventeur : **Campagnie, Bertrand**
**THOMSON-CSF SCPI 19, avenue de Messine**
**F-75008 Paris (FR)**

(74) Mandataire : **Taboureau, James et al**
**THOMSON-CSF SCPI**
**F-92045 Paris La Défense Cédex 67 (FR)**

## Description

La présente invention concerne un circuit électronique, comparateur différentiel latché autostabilisé, à préamplification et à horloge unique. Prévu pour fonctionner à très grande vitesse - dans le domaine des hyperfréquences, jusqu'à plusieurs gigahertz - son unique horloge, ses tensions de repos autostabilisées et son architecture le rendent très peu sensible aux dispersions technologiques sur la fabrication des transistors, dispersions qui entrainent des erreurs ou des instabilités de mesure.

Ce comparateur a été étudié pour être réalisé en circuit intégré sur matériaux du groupe III-V tel que GaAs, mais bien entendu il peut aussi être réalisé, sans sortir du cadre de l'invention, en silicium : sa vitesse de travail est seulement moins rapide.

Les comparateurs latchés différentiels mettent en oeuvre le mécanisme de la réaction positive : l'écart de tensions entre les entrées se retrouve après amplification, sur les sorties (Phase de mesure). C'est alors qu'on réinjecte ces signaux sur les entrées (Phase de divergence). Le fait de reboucler les sorties sur les entrées conduit à une amplification rapide des écarts de tensions.

Une telle structure, dotée d'un circuit de remise à l'équilibre, devient très intéressante puisqu'elle permet de réaliser des comparateurs dont le temps de basculement est très faible.

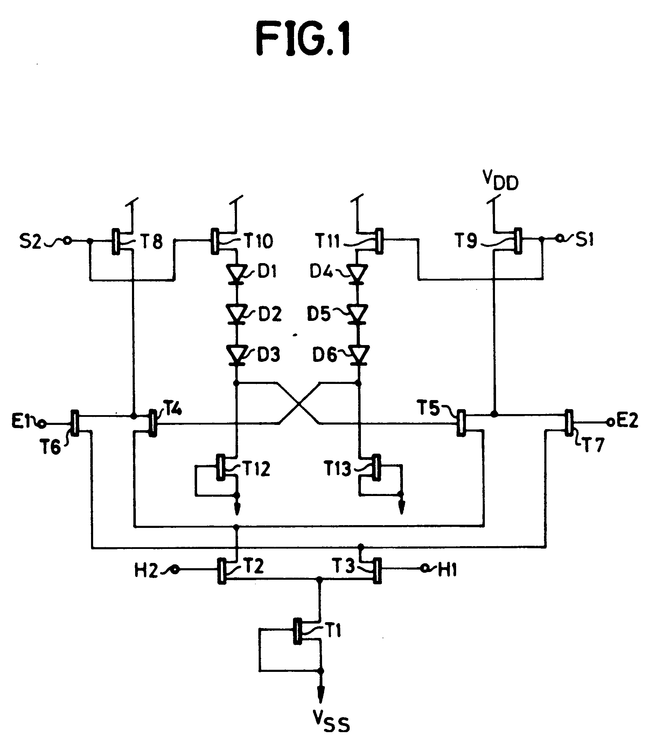

La figure 1 donne un exemple de schéma électrique de comparateur à bascule à étages différentiels imbriqués, selon l'art connu

Les signaux d'entrées $E_1$ et $E_2$, adressés sur les grilles des transistors $T_6$ et $T_7$, sont couplés avec les signaux de sorties $S_1$ et $S_2$, prélevés sur les grilles des transistors $T_8$ et $T_9$, c'est à dire aussi sur les drains des transistors $T_6$ et $T_7$. Dans cette architecture, il est nécessaire d'avoir deux horloges complémentaires, $H_1$ et $H_2$, dont les impulsions sont appliquées sur les grilles des transistors $T_2$ et $T_3$.

Ce comparateur comporte deux étages différentiels imbriqués : un étage interne $T_2 + T_4 + T_5 + T_8 + T_9$ et un étage externe $T_3 + T_6 + T_7 + T_8 + T_9$. Dans cette structure, le passage de la phase de mesure à la phase de divergence s'effectue en commutant le courant de l'étage différentiel externe à l'étage différentiel interne, an moyen des horloges et des transistors $T_2 + T_3$, et la divergence s'amorce.

Les translateurs de niveau (T10, D1,D2,D3,T12) et (T11, D4, D5, D6, T13) sont indispensables pour compenser la différence de niveaux de repos existant entre les entrées et les sorties

Les inconvénients dûs à cette struucture sont principalement :

– la nécessité d'horloges complémentaires $H_1$ et $H_2$, sans recouvrement,

– le manque de sensiblilité, dûe à l'injection de charges au cours des commutations,

– l'absence de stabilisation des niveaux de repos pour faire face aux imperfections technologiques, parce qu'il n'est pas toujours vérifié que

$$I_{T1} = I_{T4} + I_{T5}$$

– l'instabilité des signaux de sortie dure aux commutations de courant, lorsque l'on passe de l'étage externe à l'étage interne ou réciproquement.

Il est également connu du document DE-A-34 42 649 un comparateur formé par un amplificateur différentiel en premier étage et par une bascule modifiée en second étage. Les signaux de sorties du premier étage sont appliqués sur les grilles de deux transistors décaleurs de tension du second étage, lesquels sont régulièrement remis à zéro par l'action d'une horloge unique qui commande les deux transistors l'une bascule.

Ce comparateur ne comporte plus qu'ne seule horloge, et tient compte des imperfections technologiques en stabilisant les niveaux, mais il ne comporte pas l'étage d'isolement, d'où l'injection de charges au cours des commutations, avec les inconvénients que cela entraine.

Le comparateur selon l'invention permet de remédier à ces inconvénients par :

– compensation des dispersions technologiques, dûe à la stabilisation des tensions

– fonctionnement avec une horloge unique

– bonne sensibilité, par suppression du transfert de courant entre pont interne et pont externe.

Il met en oeuvre des élements de circuits qui sont en soi connus, tels qu'un amplificateur différentiel en entrée, un circuit de divergence et des translateurs de niveaux en sorties, mais le couplage entre l'amplificateur différentiel et le circuit de divergence se fait au moyen de deux suiveurs de tension qui isolent l'amplificateur du circuit de divergence. La tension de repos sur les sorties de l'amplificateur peut alors être imposée au moyen d'une boucle d'autoasservissement. Le coupage entre l'amplificateur différentiel et le circuit de divergence se fait sur la grille des transistors de charge de ce circuit, ces transistors étant eux-mêmes en série, chacun avec un transistor d'isolement qui peut fonctionner soit en mode résistif, soit en mode saturé.

De façon plus précise, l'invention concerne un comparateur différentiel latché fonctionnant à très hautes fréquences, comportant un amplificateur différentiel sur les entrées duquel sont appliqués les signaux à comparer, et un translateur de niveau de tension dont les sorties délivrent les signaux de sorties du comparateur et comportant entre l'amplificateur d'entrée et le translateur de sortie, un circuit de divergence en deux branches symétriques par rapport aux sorties le l'amplificateur, ce circuit de divergence comportant pour chaque branche au moins deux transistors montés en série : un transistor de charge couplé par sa grille à une sortie de l'amplificateur différentiel, et un transistor de rebouclage couplé par sa grille à une sortie du translateur de niveau, caractérisé en ce qu'un transistor d'isolement est montée en série entre le transistor de charge et le transistor de rebouclage dans chaque branche du circuit de divergence, la largeur de la grille du transistor d'isolement étant intermédiaire entre celle du transistor de charge et celle de l'unique transistor source de courant pour les deux branches du circuit de divergence, de sorte que les deux transistors d'isolement ne peuvent pas être saturés simultanément, l'un des deux fonctionnant en régime résistif.

L'invention sera mieux comprise, et son fonctionnement et ses avantages ressortiront mieux de la description plus détaillée qui suit maintenant, en s'appuyant sur les figures jointes en annexe, qui représentent :

 – figure 1 : schéma électrique d'un comparateur "latché" selon l'art connu, qui a déjà été décrite,

 – figure 2 : schéma électrique d'un comparateur "latché" autostabilisé et à horloge unique, selon l'invention.

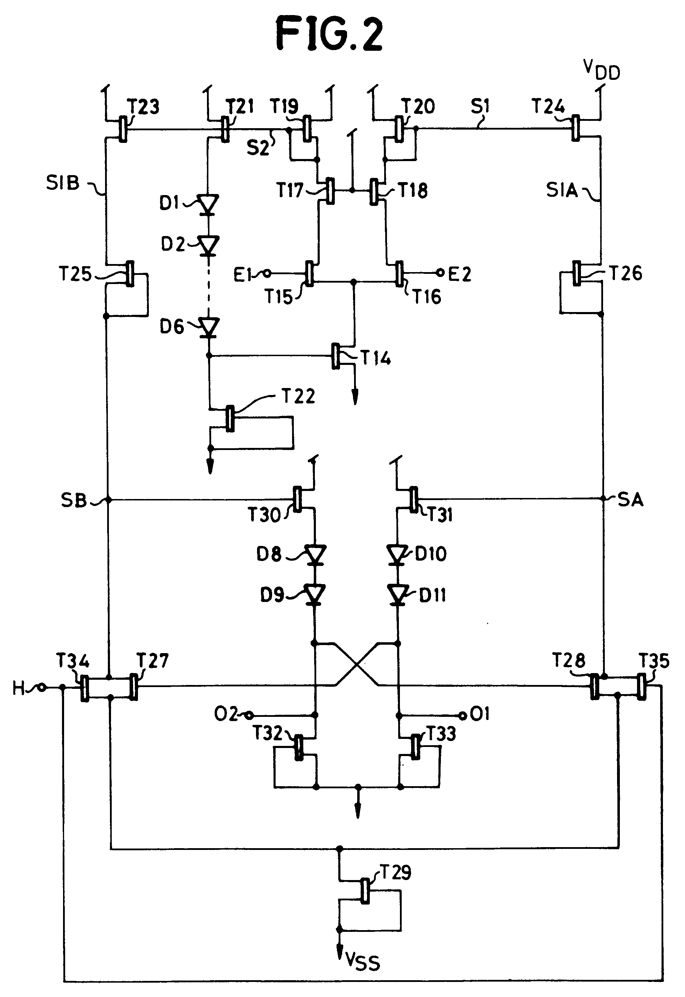

Le comparateur différentiel selon l'invention, sur la figure 2, comporte les groupes d'éléments suivants :

 – un circuit de préamplification, qui reçoit les signaux d'entrée sur ses entrées $E_1$ et $E_2$. Il est formé par un amplificateur cascodé, de type connu, qui regroupe les transistors $T_{14}$ à $T_{20}$.

 – une boucle d'autoasservissement $T_{21}$, $D_1$ à $D_6$, $T_{22}$, qui permet de stabiliser les tensions de repos sur les sorties $S_1$ et $S_2$ du préamplificateur,

 – un circuit de divergence, formé par les transistors de couplage $T_{23}$ et $T_{24}$, les transistors d'isolement $T_{25}$ et $T_{26}$, les transistors de rebouclage différentiel $T_{27}$, $T_{28}$ et $T_{29}$, et complété par deux translateurs de niveaux $T_{30}$,$D_8$,$D_9$, $T_{32}$ et $T_{31}$, $D_{10}$, $D_{11}$,$T_{33}$,

 – les transistors de remise à l'équilibre de l'ensemble $T_{34}$ et $T_{35}$, montés en parallèle avec les transistors de rebouclage $T_{27}$ et $T_{28}$, et sur la grille desquels ($T_{34}$ et $T_{35}$) est appliqué le signal de l'unique horloge H.

La sortie $O_1$ du comparateur est prise sur le drain du transistor 33 du translateur de niveau, et est simultanément rebouclée sur la grille du transistor de rebouclage $T_{27}$, et la sortie $O_2$, prise sur le drain du transistor $T_{32}$ est rebouclée sur la grille de $T_{28}$.

L'ensemble est alimenté entre deux tensions analogiques $V_{DD}$ et $V_{SS}$,ces tensions n'étant pas toutes reportées sur la figure 2 dans le seul but de ne pas la surcharger.

Le nombre de diodes, six dans la boucle d'autoasservissement, deux dans chaque translateur de niveaux, n'est pas limitatif de l'invention : il correspond à une technologie de réalisation en GaAs, mais peut différer selon la technologie mise en oeuvre. Ces diodes peuvent être remplacées par des resistances ou des transistors dans des technologies ne comportant pas de diodes.

On conviendra d'appeler SIA et SIB les sorties intermédiaires, entre les transistors de couplage et d'isolement, $T_{23}$ et $T_{25}$, $T_{24}$ et $T_{26}$, et SA et SB les sorties intermédiaires, appliquées sur les translateurs de niveaux $T_{30}$ et $T_{31}$.

Tous les transistors utilisés dans ce montage sont de type normalement passant, c'est à dire qu'ils sont conducteurs si aucune tension n'est appliquée sur leur grille.

Sommairement, le fonctionnement de ce comparateur est le suivant.

Le circuit de préamplification amplifie la différence de tension entre les deux entrées E1 et E2. Les signaux présents en sorties S1 et S2 de l'étage différentiel de préamplification sont envoyés dans l'étage de divergence grâce à un mode de couplage original par les transistors de charge $T_{23}$ et $T_{24}$ de l'étage de divergence. Si l'horloge H est au niveau logique bas, $T_{27}$ et $T_{28}$ sont conducteurs, $T_{34}$ et $T_{35}$, sont bloqués, la divergence s'amorce puisque les signaux de sortie sont envoyés sur les entrées de l'étage de divergence (grilles de $T_{27}$ et $T_{28}$). Après la divergence de SA et SB on remet le circuit à l'équilibre en plaçant l'horloge H au niveau logique haut, après quoi on peut reprendre un cycle de divergence.

De façon plus détaillée, il s'agit de comparer la tension présente sur E1 à celle sur E2. L'écart de tension V(E1) - V(E2) se trouve amplifié d'un facteur G, gain du préamplificateur. On a alors

  V(S1) - V(S2) = G. (V(E1) - V(E2)).

Dès lors il convient de considérer deux phases de fonctionnement :

 – Phase 1 : l'horloge H est à l'état logique haut : les transistors $T_{34}$ et $T_{35}$ conduisent; $T_{27}$ et $T_{28}$ sont donc court-circuités. Les transistors d'isolement $T_{25}$ et $T_{26}$ ne sont pas saturés parce que la largeur de leurs grilles est intermédiaire entre celle de la grille de la source de courant $T_{29}$ et celle de la grille des transistors de couplage $T_{23}$ et $T_{24}$. A titre d'exemple non limitatif, $T_{23}$ et $T_{24}$ ont une largeur de grille de 5 microns, $T_{25}$ et $T_{26}$ ont une largeur de 7,5 microns et $T_{29}$ une largeur de 10 microns. En effet, comme l'intensité imposée par une source de courant (transistor ayant une tension grille-source nulle) est proportionnelle à la taille du transistor, et que 2x7,5 = 15 > 10, $T_{25}$ et $T_{26}$ ne peuvent pas être tous deux saturés simultanément $T_{25}$ et $T_{26}$ fonctionnement donc en mode résistif.

En conséquence, les deux ensembles symétriques formés par les transistors de couplage, d'isolement et de remise à l'équilibre, $T_{23}$ + $T_{25}$+ $T_{34}$ et $T_{24}$ + $T_{26}$ + $T_{35}$, forment deux suiveurs-décaleurs. En effet, la tension grille-source de $T_{34}$ est égale à celle de $T_{35}$ et le courant dans la branche de gauche est égal à celui dans la branche de droite. Les tensions grilles-

sources de $T_{23}$ et $T_{24}$ sont donc égales, ainsi l'écart VS1-VS2 se reporte entre les points SIA et SIB.

$T_{25}$ et $T_{26}$ étant identiques, parcourus par un même courant et fonctionnant en mode resistif, leurs tensions drains-sources sont égales. On en déduit donc que

$$V(SA) - V(SB) = V(S1) - V(S2) = G. (V(E1) - v(E2)).$$

C'est après cette préamplification que la phase de divergence peut s'amorcer.

– Phase 2 : En phase de divergence, l'horloge H est au niveau logique bas : $T_{34}$ et $T_{35}$ sont bloqués et n'interviennent plus dans le fonctionnement du circuit. $T_{27}$ et $T_{28}$ ne sont désormais plus court-circuités. On a alors affaire à un étage différentiel latché classique. L'écart de tension V(SA) - V(SB) est réinjecté sur les grilles de $T_{27}$ et $T_{28}$, par l'intermédiaire des deux translateurs de niveaux. On assiste alors à la divergence des tensions en SA et SB, phénomène qui est très rapide. Dans ce cas, l'un des transistors $T_{25}$ ou $T_{26}$ fonctionne en régime saturé.

En resumé, un faible écart des tensions en E1 et E2 conduit rapidement à un écart important des tensions en sorties $O_1$ et $O_2$.

L'originalité de cette architecture réside dans :
– le mode de couplage entre l'étage de préamplification et l'étage de divergence par les transistors de charge $T_{23}$ et $T_{24}$ de ce dernier,
– la présence des transistors d'isolement $T_{25}$ et $T_{26}$ qui peuvent fonctionner tantôt en mode résistif, tantôt en mode saturé, et dont le rôle sera exposé plus loin,
– la boucle d'autoasservissement, permise par l'isolement du préamplificateur, dû au mode de couplage, et qui stabilise les tensions de repos,
– l'horloge unique,
la stabilisation et l'horloge unique étant des avantages engendrés par le mode de couplage.

En ce qui concerne la stabilisation de toutes les tensions de repos, la boucle d'autoasservissement $T_{21}$, $D_1$ à $D_6$, $T_{22}$ a pour rôle de stabiliser les tensions de repos en S1 et S2 par asservissement du courant dans $T_{14}$, et grâce au mode de couplage employé entre le circuit de préamplification et l'état de divergence, et puisqu'il a été démontré qu'en phase de mesure (horloge à l'état haut), les éléments $T_{23}$, $T_{25}$, $T_{34}$ ainsi que $T_{24}$, $T_{26}$ et $T_{35}$ forment deux suiveurs de tensions, les tensions de repos en SA et SB sont imposées. De plus, puisque les éléments $T_{30}$, $D_8$, $D_9$, $T_{32}$ et $T_{31}$, $D_{10}$, $D_{11}$, $T_{33}$ constituent également des suiveurs de tensions, les niveaux de repos de 01 et 02 sont également imposés. En résumé, la boucle d'auto-asservissement décrite précédemment stabilise toutes les tensions de repos du circuit.

La nécessité d'une horloge H unique, plus facile à réaliser que deux horloges complémentaires, pour passer de la phase de mesure à la phase de divergence justifie la présence des transistors d'isolement $T_{25}$ et $T_{26}$.

Dans les comparateurs "latchés" classiques il est nécessaire de disposer d'horloges complémentaires pour pouvoir envoyer sur les entrées alternativement les tensions à mesurer (phase de mesure) et celles obtenues aux sorties du différentiel (phase de divergence).

Il est possible de réaliser ces deux phases avec une horloge unique. Lorsque l'horloge H est à l'état logique bas, le comparateur se trouve en phase de divergence. Lorsque l'horloge est à l'état logique haut, la différence V(SA) - V(SB) vaut G(V(E1) - V(E2)). En phase de divergence, les entrées E1 et E2 n'ont plus d'effet sur le sens de divergence si les signaux d'entrées ne peuvent plus faire revenir le comparateur sur sa décision, ce qui est rendu possible par les transistors d'isolement $T_{25}$ et $T_{26}$. En effet considérons les étapes de fonctionnement :
– étape 1 : supposons que V(S1) - V(S2) soit faible, alors V(SA) - V(SB) est faible également durant la phase de mesure.
– étape 2 : la phase de divergence commence. Les tensions en SA et SB vont s'écarter fortement de leurs niveaux de repos. Supposons également que le signe de V(E1) - V(E2) est positif alors V(S1) > (V(S2) et V(SA) > V(SB), et pendant la phase de divergence, V(SA) croit alors que V(SB) décroît fortement.

On en déduit que la différence de tension entre S2 et SB augmente, ce qui tend à faire augmenter le courant dans $T_{23}$, courant toutefois limité par $T_{25}$ qui se place en mode saturé. Dès lors, la tension S2 n'a plus aucune influence sur V(SB) puisque ces deux noeuds sont reliés par une source de courant.

Pour ce qui est de la branche de droite, la tension entre S1 et SA diminue et $T_{26}$ se place en mode résistif.
– étape 3 : si une variation brutale des tensions d'entrée conduit au fait que V(S1) - V(S2) change de signe (V(S1) < V(S2)) pendant la phase de divergence, donc avant que l'on soit en phase de mesure, on a vu précédemment que S2 n'influence plus SB, et donc, grâce à la nature différentielle du circuit, V(S1) - V(S2) n'agit plus sur le signe de V(SA)-V(SB).

En résumé, lorsque la divergence est amorcée, les signaux d'entrée ne peuvent plus faire revenir le système sur sa décision avant que l'on ne revienne en phase de mesure.

## Revendications

1. Comparateur différentiel à bascule, fonctionnant à très hautes fréquences, comportant un amplificateur différentiel ($T_{14}$ à $T_{20}$) sur les entrées duquel sont appliqués les signaux ($E_1$, $E_2$) à comparer, et un translateur de niveau de tension ($T_{30}$, $D_7$, $D_9$, $T_{32}$) ($T_{31}$, $D_{10}$, $D_{11}$, $T_{33}$) dont les sorties délivrent des signaux de sorties ($0_1, 0_2$) du comparateur, et comportant, entre l'amplificateur d'entrée et le translateur de sortie, un circuit de divergence en deux branches symétriques par rapport aux sortie ($S1, S2$) de l'amplificateur, ce circuit de divergence comportant pour chaque branche au moins deux transistors montés en série : un transistor de charge ($T_{23}$ - $T_{24}$) couplé par sa grille à une sortie ($S_1, S_2$) de l'amplificateur différentiel et un transistor de rebouclage ($T_{27}$ - $T_{28}$) couplés par sa grille à une sortie ($0_1, 0_2$) du translateur de niveau, caractérisé en ce qu'un transistor d'isolement ($T25$,$T26$) est monté en série entre le transistor de charge et le transistor de rebouclage ($T_{27}$-$T_{28}$) dans chaque branche du circuit de divergence, la largeur de la grille du transistor d'isolement ($T_{25}$, $T_{26}$) étant intermédiaire entre celle du transistor de charge ($T_{23}$,$T_{24}$) et celle de l'unique transistor source de courant ($T_{29}$) pour les deux branches du circuit de divergence, de sorte que les deux transistors ($T_{25}$, $T_{26}$) ne peuvent pas être saturés simultanément, l'un des deux fonctionnant en régime résistif.

2. Comparateur différentiel à bascule selon la revendication 1, caractérisé en ce que les transistors d'isolement ($T_{25}$, $T_{26}$) et de charge ($T_{23}$, $T_{24}$) isolent l'amplificateur différentiel des signaux de forte amplitude présents dans le circuit de divergence.

3. Comparateur différentiel à bascule selon la revendication 2, caractérisé en ce que l'amplificateur différentiel étant isolé du circuit de divergence, ses tensions de sorties ($S_1$, $S_2$) sont stabilisées par une boucle d'autoasservissement ($T_{21}$, $D_1$ à $D_6$, $T_{22}$) qui impose la tension de repos sur la grille du transistor ($T_{14}$) source de courant de l'amplificateur

4. Comparateur différentiel à bascule selon la revendication 1, caractérisé en ce qu'un unique signal d'horloge (H) est appliqué sur les grilles de deux transistors de remise à l'équilibre ($T_{34}$, $T_{35}$), montés chacun en parallèle avec l'un des transistors ($T_{27}$, $T_{28}$) de rebouclage du circuit de divergence.

5. Comparateur différentiel à bascule selon la revendication 1, caractérisé en ce que tous les transistors du circuit sont de type normalement passant.

6. Comparateur différentiel à bascule selon l'une quelquonque des revendications 1 à 5 caractérisé en ce qu'il est employé dans un convertisseur analogique-numérique.


**Patentansprüche**

1. Differentieller Komparator mit Kippschaltung, der bei sehr hohen Frequenzen arbeitet, mit einem Differenzverstärker ($T_{14}$ bis $T_{20}$), in dessen Eingänge die zu vergleichenden Signale ($E_1$, $E_2$) eingegeben werden, und einem Spannungspegelübertrager ($T_{30}$, $D_8$, $D_9$, $T_{32}$) ($T_{31}$, $D_{10}$, $D_{11}$, $T_{33}$), dessen Ausgänge die Ausgangssignale ($O_1$, $O_2$) des Komparators liefern, und einer Divergenzschalfung zwischen dem Eingangsverstärker und dem Ausgabeüberfrager, mit zwei in bezug auf die Ausgänge ($S_1$, $S_2$) des Verstärkers symmetrischen Zweigen, wobei diese Divergenzschaltung für jeden Zweig wenigstens zwei in Reihe geschaltete Transistoren aufweist: einen Lasttransistor ($T_{23}$ - $T_{24}$), der über sein Gate an einen Ausgang ($S_1$, $S_2$) des Differenzverstärkers gekoppelt ist, und einen Wiedereinschleifungstransistor ($T_{27}$ - $T_{28}$), der über sein Gate mit einem Ausgang ($O_1$, $O_2$) des Pegelübertragers gekoppelt ist, dadurch gekennzeichnet, daß in jedem Zweig der Divergenzschaltung zwischen dem Lasttransistor und dem Wiedereinschleifungstransistor ($T_{27}$ - $T_{28}$) ein Isolationstransistor ($T_{25}$ - $T_{24}$) in Reihe geschaltet ist, wobei die Breite des Gates des Isolationstransistors ($T_{25}$, $T_{26}$) zwischen derjenigen des Lasttransistors ($T_{23}$, $T_{24}$) und derjenigen des einzigen Stromquellentransistors ($T_{29}$) für die zwei Zweige der Divergenzschaltung liegt, derart, daß die zwei Transistoren ($T_{25}$, $T_{26}$) nicht gleichzeitig gesättigt sein können, wobei einer von ihnen im Widerstandsbereich arbeitet.

2. Differentieller Komparator mit Kippschaltung gemäß Anspruch 1, dadurch gekennzeichnet, daß die Isolationstransistoren ($T_{25}$, $T_{26}$) und die Lasttransistoren ($T_{23}$, $T_{24}$) den Differenzverstärker gegenüber den in der Divergenzschaltung vorhandenen Signalen mit großer Amplitude isolieren.

3. Differentieller Komparator mit Kippschaltung gemäß Anspruch 2, dadurch gekennzeichnet, daß die Ausgangsspannungen ($S_1$, $S_2$) des gegenüber der Divergenzschaltung isolierten Differenzverstärkers durch einen Selbstregelkreis ($T_{21}$, $D_1$ bis $D_6$, $T_{22}$) stabilisiert werden, der an das Gate des Transistors ($T_{14}$) der Verstärker-Stromquelle die Ruhespannung anlegt.

4. Differentieller Komparator mit Kippschaltung gemäß Anspruch 1, dadurch gekennzeichnet, daß an die Gates der zwei Transistoren ($T_{34}$, $T_{35}$) für die Wiederherstellung des Gleichgewichts, die jeweils zu einem der Wiedereinschleifungstransistoren ($T_{27}$, $T_{28}$) der Divergenzschaltung parallel geschaltet sind, ein einziges Taktsignal (H) angelegt wird.

5. Differentieller Komparator mit Kippschaltung gemäß Anspruch 1, dadurch gekennzeichnet, daß sämtliche Transistoren der Schaltung vom normalerweise durchlassenden Typ sind.

6. Differentieller Komparator mit Kippschaltung gemäß einem der Ansprüche 1 bis 5, dadurch gekennzeichnet, daß er in einem Analog-/Digital-Umsetzer verwendet wird.


**Claims**

1. A bistable differential comparator, functionning at very high frequencies, comprising a differential

amplifier ($T_{14}$ through $T_{20}$) to whose inputs the signals ($E_1$ and $E_2$) to be compared are applied, and a voltage level translator ($T_{30}$, $D_8$, $D_9$ and $T_{32}$) ($T_{31}$, $D_{10}$, $D_{11}$ and $T_{33}$) whose outputs supply the output signals ($O_1$ and $O_2$) of the comparator, comprising, between the input amplifier and the output translator, a divergence circuit having two limbs, which are symmetrical in relation to the output (S1 and S2) of the amplifier, said divergence circuit comprising for each limb at least two transistors connected in series: a load transistor ($T_{23}$ and $T_{24}$) coupled by its gate with one output (S1 and S2) of the differential amplifier and a feedback transistor ($T_{27}$ and $T_{28}$) coupled by means of its gate with one output ($O_1$ and $O_2$) of the level translator, characterized in that an isolating transistor ($T_{25}$ and $T_{26}$) is connected in series between the load transistor and the feedback transistor ($T_{27}$ and $T_{28}$) in each limb of the divergence circuit, the width of the gate of the isolating transistor ($T_{25}$ and $T_{26}$) being intermediate between that of the load transistor ($T_{23}$ and $T_{24}$) and that of the single current source transistor ($T_{29}$) for the two limbs of the divergence circuit so that the two transistor ($T_{25}$ and $T_{26}$) are not able to be simultaneous saturated, one of the same operating in a resistance mode.

2. The bistable differential comparator as claimed in claim 1, characterized in that the isolating transistor ($T_{25}$ and $T_{26}$) and the load transistor ($T_{23}$ and $T_{24}$) isolate the differential amplifier from high amplitude signals present in the divergence circuit.

3. The bistable differential comparator as claimed in claim 2, characterized in that, the differential amplifier being isolated from the divergence circuit, its output voltages ($S_1$ and $S_2$) are stabilized by a servo control loop ($T_{21}$ $D_1$ through $D_6$ and $T_{22}$) which applies the resting condition voltage to the gate of the source of current transistor ($T_{14}$) of the amplifier.

4. The bistable differential comparator as claimed in claim 1, characterized in that a single clock signal (H) is applied to the gate of the two equilibrium restoring transistor ($T_{34}$ and $T_{35}$) each connected in parallel with one of the feedback transistors ($T_{27}$ and $T_{28}$) of the divergence circuit.

5. The bistable differential comapator as claimed in claim 1, characterized in that all the transistors of the circuit are of the normally conducting type.

6. The bistable differential comparator as claimed in any one of the preceding claim 1 through 5, characterized in that it is utilized in an analog-digital converter.

# FIG.1

# FIG.2